Europäisches Patentamt

European Patent Office

Office européen des brevets

(19)

(11) Veröffentlichungsnummer: **0 122 563**
**B1**

(12)

# EUROPÄISCHE PATENTSCHRIFT

(45) Veröffentlichungstag der Patentschrift:
**30.03.88**

(51) Int. Cl.⁴: **G 01 R 31/26**, H 01 J 37/252

(21) Anmeldenummer: **84103821.9**

(22) Anmeldetag: **06.04.84**

(54) **Verfahren zur Abbildung von elektrischen Sperrschichten (pn-Übergängen) in Halbleitern durch Verarbeitung von korpuskularstrahlinduzierten Signalen im Raster-Korpuskularmikroskop.**

(30) Priorität: **14.04.83 DE 3313597**

(43) Veröffentlichungstag der Anmeldung:
**24.10.84 Patentblatt 84/43**

(45) Bekanntmachung des Hinweises auf die Patenterteilung:
**30.03.88 Patentblatt 88/13**

(84) Benannte Vertragsstaaten:
**DE FR GB NL**

(56) Entgegenhaltungen:
SOLID-STATE ELECTRONICS, Band 19, Nr. 11,
November 1976, Seiten 921-925, PERGAMON PRESS.
(GB) J. KAMM: "A method for investigation of
fluctuations in doping concentration and
minority-carrier diffusion lenght in semiconductors by
scanning electron microscope
JOURNAL OF APPLIED PHYSICS, Band 53, Nr. 6, Juni
1982, Seiten R51-R80, NEW YORK, (US) H. LEAMY:
"Charge collection scanning electron microscopy".

(73) Patentinhaber: **Siemens Aktiengesellschaft Berlin und München, Wittelsbacherplatz 2, D-8000 München 2 (DE)**

(72) Erfinder: **Rehme, Hans, Dr., Herzog-Albrecht-Strasse 13, D-8011 Zorneding (DE)**
Erfinder: **Schink, Helmut, Dipl.-Phys., Knappertsbuschstrasse 5, D-8000 München 81 (DE)**

## Beschreibung

Verfahren zur Abbildung elektrischer Sperrschichten (pn-Übergängen) in Halbleitern.

Die Erfindung betrifft ein Verfahren zur Abbildung elektrischer Sperrschichten (pn-Übergängen) in Halbleitern nach dem Oberbegriff der Patentansprüche 1, 2 und 3.

Für die Entwicklung hochintegrierter Bauelemente ist die genaue Kenntnis der im Innern des Halbleiterkristalls vorliegenden Potential- bzw. Dotierstoffverteilung von Bedeutung. Tiefenabhängige Dotierstoffprofile können mittels Computer-Simulation berechnet oder beispielsweise mittels Sekundärionen-Massenspektrometrie (SIMS) gemessen werden. Die Tiefe eines pn-Übergangs lässt sich durch elektrische Messungen ermitteln.

Wegen der zunehmenden Miniaturisierung sind aber auch die durch Streuung oder Diffusion des Dotierstoffes hervorgerufenen lateralen Effekte von grosser Bedeutung, z.B. die Unterdiffusion an Maskenkanten. Die Messung dieser lateralen Effekte mit hinreichend guter Ortsauflösung (ca. 0,1 μm) ist ein bisher nicht gelöstes Problem.

Ein Verfahren zur Bestimmung der Fluktuation der Dotierstoffkonzentration in Halbleitern ist aus der Veröffentlichung von J.D. Kamm, Solid-State Electronics, Band 19, Nr: 11, November 1976, Seite 921 bis 925 bekannt. Die in der Raumladungszone eines Schottky-Übergangs mit Hilfe eines Elektronenstrahls erzeugten Elektronen-Loch-Paare führen zu einem von der Dotierstoffkonzentration abhängigen Photostrom, den man in Abhängigkeit vom Ort des rasternden Elektronenstrahles auf der Halbleiterprobe aufzeichnet.

Weiterhin ist bekannt, pn-Übergänge mit Hilfe des induzierten Probenstromes (EBIC: electron beam induced current) in einem Rasterelektronenmikroskop abzubilden. Mit einem solchen bekannten Verfahren kann jedoch der Verlauf eines pn-Übergangs nicht mit der erforderlichen Genauigkeit dargestellt werden.

Der vorliegenden Erfindung liegt die Aufgabe zugrunde, ein Verfahren der eingangs genannten Art anzugeben, das die Abbildung von elektrischen Sperrschichten, z.B. von pn-Übergängen, in Halbleitern mit einer sehr hohen Genauigkeit auch dann ermöglicht, wenn diese elektrischen Sperrschichten senkrecht oder schräg zur Probenoberfläche gerichtet sind. Zum Beispiel soll in Querschnitten durch Halbleiter-Bauelemente der Verlauf von pn-Übergängen mit einer Unsicherheit von höchstens 0,1 μm bestimmt werden.

Diese Aufgabe wird erfindungsgemäss durch Verfahren nach den Ansprüchen 1, 2 und 3 gelöst. Ausgestaltungen und Vorteile der erfindungsgemässen Verfahren sind in den Unteransprüchen, der Beschreibung und der Zeichnung dargestellt.

Ausführungsbeispiele der Erfindung werden im folgenden anhand der Zeichnung näher beschrieben.

Fig. 1 zeigt eine Anordnung zur Abbildung eines pn-Überganges mit Hilfe des induzierten Probenstromes (EBIC) nach dem Stand der Technik.

Fig. 2 zeigt schematisch das Ergebnis einer Linienabtastung (Rasterlinie, line scan) quer zum pn-Übergang mit einer Anordnung nach Fig. 1 nach dem Stand der Technik.

Die Figuren 3 bis 5 verdeutlichen das der Erfindung zugrundeliegende Prinzip, das erst eine Lokalisierung eines pn-Übergangs mit der geforderten Genauigkeit ermöglicht.

Die Figuren 6 bis 9 erläutern Ausführungsbeispiele der Erfindung zur Lokalisierung von elektrischen Sperrbereichen.

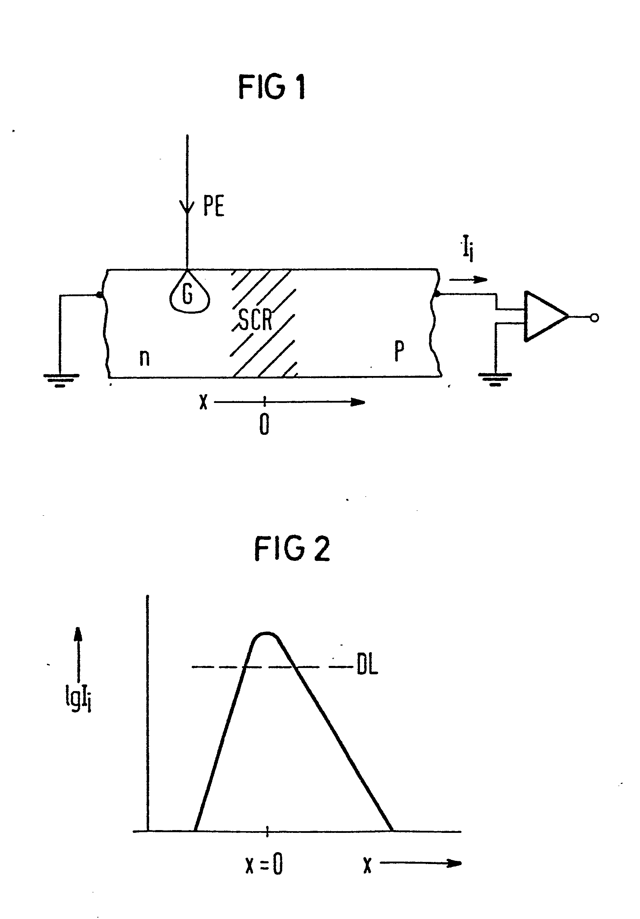

Die Fig. 1 zeigt eine Anordnung zur Abbildung eines pn-Übergangs mit Hilfe des induzierten Probenstromes (EBIC) in einem Raster-Elektronenmikroskop sowie die Beschaltung der Probe. Primärelektronen PE mit einer Energie von z.B. 20 keV dringen in die Probe ein. Diese Primärelektronen PE werden dabei gestreut und verlieren ihre Energie in einem in Fig. 1 kugelförmig angenommenen Volumen G. In diesem «Streuvolumen» G erzeugen die Primärelektronen PE durch Ionisation Elektron-Loch-Paare. Befindet sich das Streuvolumen G in hinreichend grossem Abstand vom pn-Übergang, dann rekombinieren die Elektronen und Löcher wieder miteinander, nachdem sie im Mittel einen ihrer jeweiligen Diffusionslänge entsprechenden Weg zurückgelegt haben.

Wandert der Primärelektronenstrahl in x-Richtung über die Probenoberfläche hinweg und nähert sich dem pn-Übergang, dann gelangen schliesslich diffundierende Ladungsträger in den Einflussbereich des elektrischen Feldes der Raumladungszone SCR. Von diesem elektrischen Feld werden die jeweiligen Minoritätsträger auf die jeweils andere Seite des pn-Übergangs beschleunigt (Elektronen auf die n-Seite, Löcher auf die p-Seite). Bei geschlossenem äusseren Stromkreis ist ein «Ladungstrennungsstrom» $I_i$ (EBIC), der gemessen, verstärkt und beispielsweise zur Helligkeitsmodulation der Bildröhre des Raster-Elektronenmikroskops genutzt werden kann, vorhanden.

Fig. 2 zeigt schematisch das Ergebnis einer Linienabtastung (Rasterlinie, line scan) quer zum pn-Übergang. In Fig. 2 ist der Ladungstrennungsstrom $I_i$ in logarithmischem Massstab aufgetragen. In hinreichend grossem Abstand vom pn-Übergang wird der Kurvenverlauf des Ladungstrennungsstromes $I_i$ durch

$$I_i = I_{im} \exp\left(-[x]/L\right)$$

beschrieben ($I_i$: Induzierter Probenstrom bzw. EBIC, $I_{im}$: grösstmöglicher Wert von $I_i$, L: Diffusionslänge der jeweiligen Minoritätsträger).

Für kleine Absolutwerte von x überlappen sich das Streuvolumen $G$ und die Raumladungszone SCR und dann ist allerdings diese eben angegebene Beziehung für den Ladungstrennungsstrom $I_i$ ungültig. Insbesondere ist in der Regel $I_i$ (x = 0) kleiner als $I_{im}$. Wie gross der induzierte Strom $I_i$ am pn-Übergang tatsächlich ist, hängt vom Durchmesser des Streuvolumens G, von der Breite der Raumladungszone SCR und vom Einfluss der Oberflächenrekombination ab.

Um einen pn-Übergang zu lokalisieren, ist die Kenntnis der Grösse des Ladungstrennungsstromes $I_i$ nicht erforderlich. Man kann zunächst davon ausgehen, dass das Korpuskularstrahl-induzierte Signal $I_i$ am pn-Übergang, d.h. an der Stelle grösster Feldstärke, am höchsten ist. Dies trifft bei symmetrischer Feldverteilung sicher zu. Dann ist es nur notwendig, denjenigen Ort zu finden, an dem der Ladungstrennungsstrom $I_i$ seinen maximalen Wert besitzt. Die exponentiellen Ausläufer des Ladungstrennungsstromes $I_i$ beiderseits des pn-Übergangs können daher in erfindungsgemässer Weise elektronisch unterdrückt werden. Dazu wird eine dark level-Einstellung verwendet, die die exponentiellen Ausläufer des Ladungsträgerstromes $I_i$ für solche Werte, die kleiner sind als ein bestimmter Wert DL, unterdrückt. Die pn-Übergänge erscheinen dadurch in Abbildungen als schmale, helle Linien. Schwankungen des maximalen Ladungstrennungsstromes $I_i$ während des Abrasterns eines pn-Übergangs begrenzen die Anwendbarkeit dieser Methode. Um den Einfluss dieser Unregelmässigkeiten zu unterdrücken und eine noch genauere Lokalisierung zu ermöglichen, werden anhand von folgenden Figuren weitergehende Messmethoden vorgeschlagen.

Der Ladungstrennungsstrom $I_i$ kann als ein EBIC-Profil $I_i$ (x), wie in Fig. 2 dargestellt, oder als eine zweidimensionale EBIC-Abbildung $I_i(x,y)$ dargestellt werden. Um eine zweidimensionale EBIC-Abbildung $I_i(x,y)$ zu erhalten, wird mit Hilfe des Ladungstrennungsstromes $I_i(x,y)$ die Helligkeit der Bildröhre des Raster-Elektronenmikroskops gesteuert. Eine helle Linie erscheint entlang dem pn-Übergang, deren Breite von dem Ladungstrennungsstrom-Profil und dem zugehörigen Niveau DL zur Unterdrückung der exponentiellen Ausläufer des Ladungstrennungsstrom-Profiles abhängt.

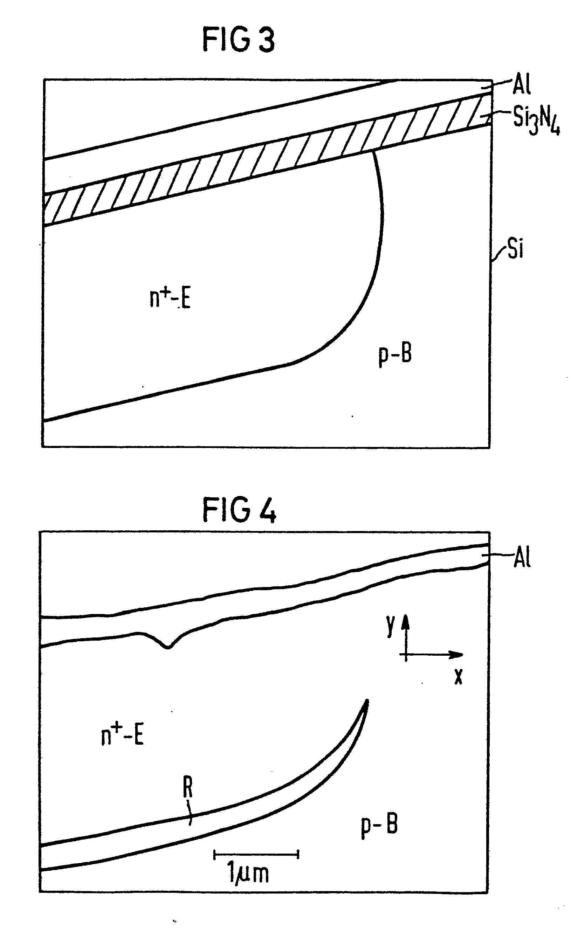

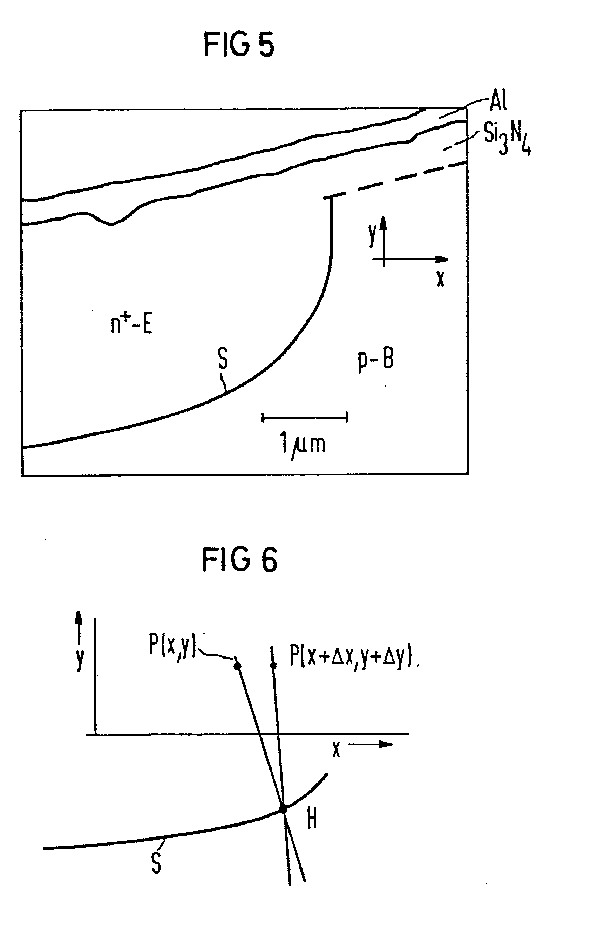

Die Fig. 3, 4 und 5 zeigen schematisch eine in Silizium-Gatetechnik hergestellte Probe. Das mit einer $Si_3N_4$-Schicht bedeckte Siliziumplättchen Si ist mit einer Aluminiumschicht Al überzogen. Die Fig. 3, 4 und 5 zeigen einen Emitter $(n^+-E)$-Basis (p–B)-Übergang. In der Nachbarschaft der $Si_3N_4$-Passivierungsschicht verschwindet das EBIC-Signal $I_i$, weil in der Nachbarschaft dieser Passivierungsschicht die Grösse des Maximums des EBIC-Signals $I_i$ wegen der erhöhten Rekombination an der Grenzschicht kleiner ist als das Niveau DL (siehe Fig. 2) und weil daher das EBIC-Signal $I_i$ in der Nachbarschaft der Passivierungsschicht vollständig unterdrückt wird (Fig. 4). Eine Erniedrigung des Niveaus DL (siehe Fig. 2) würde in Fig. 4 zu einer weiteren Verbreiterung des EBIC-Signals R in denjenigen Bereichen des pn-Übergangs führen, die nicht dieser Passivierungsschicht benachbart sind. Damit würde jedoch die Lokalisierung des pn-Übergangs in diesen der Passivierungsschicht nicht benachbarten Bereichen noch ungenauer werden. Um diese Probleme mit Auswirkungen von Grenzschichten und Oberflächen zu umgehen und um eine höhere Ortsauflösung zu erhalten, werden im folgenden verschiedene Methoden vorgeschlagen, bei denen das EBIC-Signal $I_i$ mit Hilfe eines Rechners verarbeitet wird. Mit Hilfe eines Tischrechners HP9826 können dabei beispielsweise $324 \times 243$ Punkte mit einer 12-Bit Auflösung gespeichert und verarbeitet werden. Nachdem das gesamte zweidimensionale EBIC-Bild $I_i(x,y)$ in den Rechner eingespeichert worden ist, können die Maxima des EBIC-Signals $I_i(x,y)$ ermittelt werden. Falls der Winkel zwischen der Richtung der Zeilenabtastung und dem pn-Übergang nicht zu klein ist, kann beispielsweise im einfachsten Fall das zweidimensionale EBIC-Signal $I_i(x,y)$ Zeile für Zeile ermittelt werden. Durch Drehen der Probe oder der Abtastrichtung der Rastersonde kann in den meisten Fällen ein zu kleiner Winkel zwischen der Abtastrichtung zur Abtastsonde und dem pn-Übergang vermieden werden. Mit Hilfe eines entsprechenden Algorithmus kann der störende Einfluss von Rauschen unterdrückt werden. Die mit Hilfe des Rechners ermittelten Resultate können auf einem Plotter oder auf dem Bildschirm des Raster-Elektronenmikroskops ausgegeben werden. In letzterem Fall kann, wie bei bekannten EBIC-Bildern, ein Teilbereich der Abbildung mit Hilfe von Sekundärelektronen erzeugt werden, wie dies in Fig. 5 dargestellt ist. Im Gegensatz zur Darstellung in Fig. 4 ist in Fig. 5 der pn-Übergang S entlang seiner gesamten Länge mit konstantem Kontrast und mit konstanter Breite dargestellt. Die Linienbreite ergibt sich aus dem Verfahren, wie die Abbildung erzeugt wird: Da das Maximum des EBIC-Signals $I_i$ nicht scharf ist, ergibt sich bei der Digitalisierung des EBIC-Signals für das Maximum dieses EBIC-Signals ein Plateau von etwa zwei oder drei Punkten, die einer Linienbreite von etwa 50 nm in Fig. 5 entsprechen. Eine zusätzliche Verbreiterung der Linienbreite ist durch die Digitalisierung des Bildfeldes verursacht.

Für die Verwendung eines Rechners wird vorausgesetzt, dass das Raster-Elektronenmikroskop einen digitalen Rastergenerator besitzt, der z.B. 1000 Zeilen pro Bild und 1000 Punkte pro Zeile anzusteuern gestattet. Mit einem Rechner müssten bei jedem Zeilendurchlauf die EBIC-Signalhöhen aller 1000 Bildpunkte der betreffenden Zeile abgespeichert werden. Nach dem Zeilendurchlauf hat der Rechner den Punkt bzw. (bei mehreren pn-Übergängen) die Punkte höchsten EBIC-Signals zu ermitteln und erst dann auf dem Bildschirm durch einen hellen Punkt zu markieren. Diese Markierung kann durch Zurückspringen auf der gleichen Zeile oder beim nächsten Zeilendurchlauf erfolgen. In letzterem Fall würde der Lokalisierungsfehler bei 5000facher Vergrösserung nur 20 nm betragen und wäre zu vernachlässigen.

Die Fig. 6, 7 und 8 zeigen weitergehende Methoden zur genauen Lokalisierung von elektrischen Sperrbereichen. Bei der Methode nach Fig. 6 können beispielsweise durch zeilenweises Abrastern der Probenoberfläche und durch entsprechendes Einspeichern der resultierenden EBIC-Signale $I_i$ in einen Rechner sogenannte Höhenlinien, das sind Linien in der x-y-Ebene, die solche Punkte miteinander verbinden, an denen die Werte der EBIC-Signale etwa übereinstimmen, ermittelt werden.

Daraus können wiederum die Maxima in x- und y-Richtung angegeben werden. Diese Maxima können als eine nullte Näherung für die Lokalisierung eines pn-Übergangs S herangezogen werden. Falls der pn-Übergang Krümmungen aufweist, kann dieser pn-Übergang S in verschiedene Bereiche aufgeteilt werden, von denen jeder Bereich eine einigermassen definierbare Krümmung mit einem einigermassen definierbaren Krümmungsmittelpunkt aufweist. In der Nähe solcher Krümmungsmittelpunkte wird jeweils ein Punkt (P(x,y) definiert, von dem ausgehend auf etwa kürzestem Weg über verschiedene Punkte H, die auf dem zu diesem Krümmungsmittelpunkt zugehörigen Teilbereich des pn-Übergangs S liegen, jeweils eine Linie abgetastet wird. Für jede solche Linienabtastung wird ein EBIC-Signal $I_i$ aufgezeichnet. Für jedes dieser EBIC-Signale $I_i$ wird das Maximum ermittelt. Dabei wird entlang einer jeden Linienabtastung jeweils über eine Reihe von hintereinanderliegenden Punkten gemittelt, um Störeffekte auszuschliessen. Dabei kann die Anzahl von hintereinanderliegenden Punkten, über die jeweils gemittelt wird, solange verändert werden, bis die Hinzunahme oder das Weglassen eines einzelnen Punktes bei der Mittelung über eine bestimmte Anzahl von hintereinanderliegenden Punkten praktisch keine Änderung des Ergebnisses mehr bewirkt.

In der Nachbarschaft des Punktes P(x,y) wird sodann ein weiterer Punkt P(x + Δx, y + Δy) ausgewählt, mit dem entsprechend der in bezug auf den Punkt P(x,y) geschilderten Methode verfahren wird. Ergibt sich dabei eine Lokalisierung des zu diesem Krümmungsbereich zugehörigen Teilbereichs des pn-Übergangs, die mit derjenigen Lokalisation übereinstimmt, die bei dem ersten Verfahrensschritt ausgehend vom Punkt P(x,y) gefunden worden ist, so ist diese Lokalisation des Teilbereiches des pn-Übergangs S bereits zuverlässig. Stimmen die beiden hintereinander ermittelten Lokalisierungen des Teilbereiches des pn-Übergangs nicht miteinander überein, so müssen solange weitere Punkte P in der Nachbarschaft eines für den unmittelbar vorhergehenden Verfahrensschritt benutzten Punktes gesucht und für einen weiteren Verfahrensschritt benutzt werden, bis mindestens zwei unmittelbar hintereinander durchgeführte Lokalisierungen des Teilbereiches des pn-Übergangs praktisch übereinstimmen.

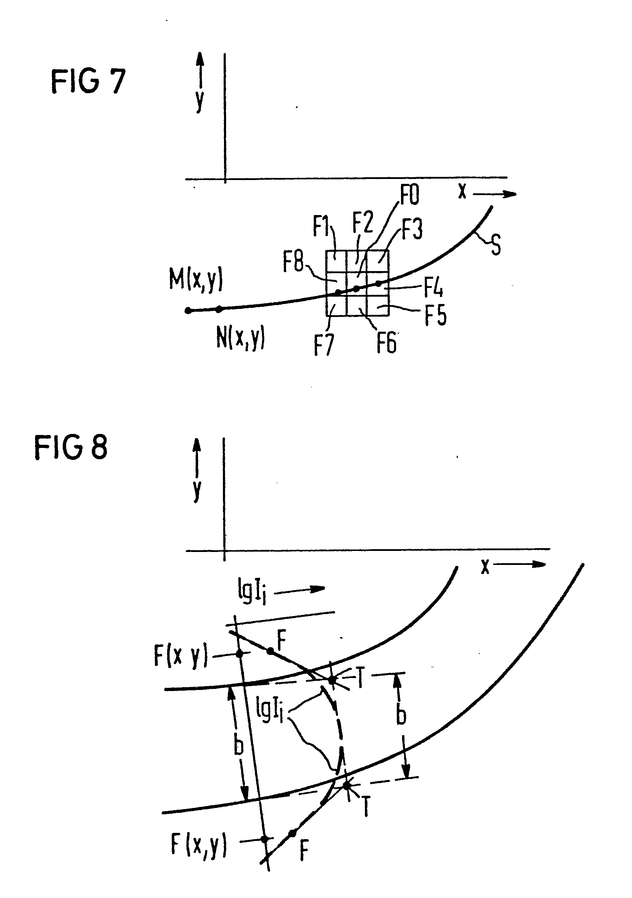

Bei der Methode nach Fig. 7 wird zunächst das absolute Maximum der Werte des EBIC-Signals $I_i$ des ganzen Bildes ermittelt. In der Umgebung dieses absoluten Maximums M(x,y) werden durch Zusammenfassung von jeweils benachbarten Punkten Felder definiert, um Störeffekte zu unterdrücken. Für jedes dieser Felder wird der mittlere Wert des EBIC-Signals $I_i$ ermittelt. Da das absolute Maximum M(x,y) auf dem pn-Übergang S liegt, liegt auch dasjenige Feld um den Punkt N(x,y) auf dem pn-Übergang S, das nach dem Wert des absoluten Maximums den zweitgrössten Wert des EBIC-Signals $I_i$ aufweist. Ausgehend von dem Feld um den Punkt N(x,y) wird sodann ein weiteres Feld gesucht, dessen Wert des EBIC-Signals $I_i$ den

grössten Wert aller in der unmittelbaren Nachbarschaft des Punktes N(x,y) ermittelten EBIC-Signale $I_i$ aufweist, wobei die Werte von Punkten, die bereits als zum pn-Übergang S zugehörig identifiziert worden sind, nicht mehr berücksichtigt werden dürfen. Auf diese Weise kann sukzessive, immer wieder ausgehend vom zuletzt ermittelten Punkt auf dem pn-Übergang S, der gesamte Verlauf des pn-Übergangs S definiert werden.

Die Grösse der Felder von Punkten, über die jeweils gemittelt wird, wird solange verändert, bis die Hinzunahme oder das Weglassen eines Punktes aus einem solchen Feld die Lokalisierung des pn-Übergangs S praktisch nicht mehr verändert.

Fig. 8 erläutert eine weitere Methode für den Fall, dass die Breite der Raumladungszone SCR gross im Vergleich zum Durchmesser des Streuvolumens G ist. In diesem Fall weist das EBIC-Profil $I_i$ ein Plateau auf. Dabei wird zunächst die Konstanz des Plateauwertes des EBIC-Signals $I_i$ innerhalb der Raumladungszone SCR über einen gewissen Bereich des pn-Übergangs hinweg mittels mehrerer Linienabtastungen kontrolliert. Bei jeder Linienabtastung werden die gemessenen EBIC-Signale $I_i$ logarithmiert. Die exponentiellen Ausläufer des EBIC-Signals $I_i$ werden dabei annähernd zu Geraden. Bei jeder Linienabtastung werden auf der ansteigenden und auf der abfallenden Flanke des EBIC-Signals $I_i$ die Punkte F auf dem logarithmierten Signal $I_i$ ermittelt, bei denen das logarithmierte Signal $I_i$ etwa lineare Flanken aufweist. Sodann wird die Steigung des logarithmierten Signals $I_i$ in diesen Punkten F ermittelt, und zwar zweidimensional. Durch die Punkte F auf dem logarithmierten Signal $I_i$ werden sodann mit diesen ermittelten Steigungen Geraden gelegt, die mit einer weiteren horizontal durch das Maximum des logarithmierten Signals $I_i$ verlaufenden Geraden zwei Schnittpunkte T aufweisen. Diese Schnittpunkte T definieren die Breite b des pn-Übergangs über ihren Abstand b.

Bisher wurde immer davon ausgegangen, dass das Maximum des Signals $I_i$ mit dem pn-Übergang zusammenfällt. Diese Annahme ist erfüllt, solange das elektrische Feld in der Raumladungszone SCR symmetrisch ist und solange die Diffusionslängen der jeweiligen Minoritätsladungsträger von vergleichbarer Grösse sind. Wenn aber die Dotierstoffkonzentrationen im n- und p-Gebiet sehr unterschiedlich sind, wie dies zumeist der Fall ist, sind die elektrische Feldverteilung unsymmetrisch und die Diffusionslängen verschieden. Dann fallen Maximum des EBIC-Signals $I_i$ und np-Übergang nicht exakt zusammen.

Eine Abschätzung des Beispiels aus den Fig. 2, 4 und 5 (Emitter-Dotierstoffkonzentration: $10^{20}$ cm$^{-3}$, Basis-Dotierstoffkonzentration: $10^{18}$ cm$^{-3}$) liefert eine Abweichung Δx des pn-Übergangs vom Maximum des EBIC-Signals $I_i$ von etwa 10 nm. Dies bedeutet, dass der wahre Emitter-Basis-Übergang in vernachlässigbarer Weise zum Emitter hin verschoben ist. Um diesen Fehler Δx möglichst klein zu halten, sollte das Streuvolumen G möglichst klein sein. Zu diesem Zweck muss bei möglichst niedriger Beschleunigungsspannung für die Primärelektronen PE gearbeitet werden.

In Fig. 7 sind Felder F0 bis F8 eingezeichnet. Jedes der Felder F0 bis F8 liefert einen Wert des EBIC-Signals $I_i$, der über die im jeweiligen Feld enthaltenen Rasterpunkte gemittelt worden ist. Die Werte für die Felder F0 bis F8 werden nicht berücksichtigt, weil sie schon als zum Sperrbereich zugehörig identifiziert worden sind. Unter den übrigen Feldern F1 bis F7 weist das Feld F4 den höchsten gemittelten Wert für das EBIC-Signal $I_i$ auf. Also gehört auch Feld F4 zum elektrischen Sperrbereich.

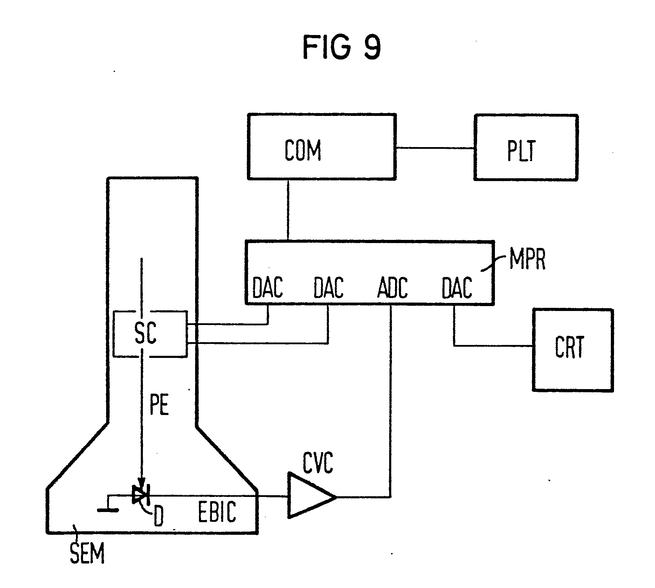

Fig. 9 zeigt das Blockdiagramm einer Anordnung zur Durchführung eines erfindungsgemässen Verfahrens. In einem Raster-Elektronenmikroskop SEM dringen die Primärelektronen PE in die Probe D ein. Die Probe D ist in Fig. 9 als Diode dargestellt. Bei geschlossenem äusseren Stromkreis fliesst ein «Ladungstrennungsstrom» EBIC. Dieses EBIC-Signal wird in einem Strom-/Spannungswandler CVC (Keithley 427) in ein Spannungssignal umgewandelt. Dieses Spannungssignal wird über einen Analog/-Digital-Wandler ADC einem Multiprogrammer MPR (HP 6940B) zugeführt. Diese Messsignale werden in einem Computer COM (HP 9826A) verarbeitet. Messergebnisse können über einen Plotter PLT (HP 9872A) dargestellt werden. Die Ablenkung der Primärelektronen PE wird ebenfalls vom Computer COM gesteuert. Zu diesem Zweck werden über Digital/-Analog-Wandler DAC, die zum Multiprogrammer MPR gehören, Signale an die Ablenkspulen SC des Raster-Elektronenmikroskops SEM übermittelt. Messergebnisse können auch über einen weiteren Digital/-Analog-Konverter DAC, der ebenfalls zum Multiprogrammer MPR gehört, auf dem Bildschirm CRT, der beispielsweise zum Raster-Elektronenmikroskop SEM gehört, dargestellt werden.

**Patentansprüche**

1. Verfahren zur Abbildung elektrischer Sperrschichten in Halbleitern, deren Oberfläche von einem in einem Rastermikroskop erzeugten Korpuskularstrahl punkt- oder zeilenweise abgetastet wird und bei dem korpuskularstrahl-induzierte Signale in Abhängigkeit vom Ort des Korpuskularstrahls auf der Halbleiteroberfläche aufgezeichnet werden, dadurch gekennzeichnet, dass ein erster Rasterpunkt (P(x,y)) so ausgewählt wird, dass korpuskularstrahl-induzierte Signale, die entlang mindestens einer Rasterlinie (line scan) erzeugt werden, wobei die mindestens eine Rasterlinie von dem ersten Rasterpunkt (P(x,y)) ausgehend auf etwa kürzestem Weg über jeweils einen auf der zu lokalisierenden elektrischen Sperrschicht liegenden weiteren Punkt (H) hinwegführt, praktisch mit den entsprechenden korpuskularstrahl-induzierten Signalen übereinstimmen, die dadurch erzeugt werden, dass einer jeden der obengenannten Rasterlinien jeweils eine andere Rasterlinie entspricht, die nunmehr nicht von dem ersten Rasterpunkt (P(x,y)), sondern von einem dem ersten Rasterpunkt (P(x,y)) benachbarten zweiten Rasterpunkt (P(x+Δx, y+Δy)) ausgeht und wenigstens in der Nähe des jeweils zugehörigen weiteren Punktes (H) über die zu lokalisierende elektrische Sperrschicht hinwegführt, wobei das jeweilige Maximum der korpuskularstrahl-induzierten Signale entlang einer jeden solchen Rasterlinie dann mit einem Punkt auf der elektrischen Sperrschicht (S) korreliert ist.

2. Verfahren zur Abbildung elektrischer Sperrschichten in Halbleitern, deren Oberfläche von einem in einem Rastermikroskop erzeugen Korpuskularstrahl punkt- oder zeilenweise abgetastet wird und bei dem korpuskularstrahl-induzierte Signale in Abhängigkeit vom Ort des Korpuskularstrahls auf der Halbleiteroberfläche aufgezeichnet werden, dadurch gekennzeichnet, dass ein erster Rasterpunkt (M(x,y)) derart ausgewählt wird, dass das an diesem ersten Rasterpunkt (M(x,y)) gemessene korpuskularstrahl-induzierte Signal, verglichen mit den anderen Rasterpunkten gemessenen korpuskularstrahl-induzierten Signalen, den höchsten Wert aufweist, dass ausgehend von dem ersten Rasterpunkt (M(x,y)) ein zweiter Rasterpunkt (N(x,y)) in dessen unmittelbarer Umgebung derart ausgewählt wird, dass das an diesem zweiten Rasterpunkt (N(x,y)) gemessene korpuskularstrahl-induzierte Signal, verglichen mit den an den in der unmittelbaren Umgebung des ersten Rasterpunktes (M(x,y)) liegenden weiteren Rasterpunkten gemessenen korpuskularstrahl-induzierten Signalen, den höchsten Wert aufweist, wobei das am ersten Rasterpunkt (M(x,y)) gemessene korpuskularstrahl-induzierte Signal nicht berücksichtigt wird, dass in der unmittelbaren Umgebung des zweiten Rasterpunktes (N(x,y)) ein dritter Rasterpunkt ausgewählt wird, dessen korpuskularstrahl-induzierte Signal unter Nichtberücksichtigung der an dem ersten und zweiten Rasterpunkt (M(x,y), N(x,y)) gemessenen Signale den höchsten Wert aufweist, und so fort, wobei die Folge der so ausgewählten Rasterpunkte (M(x,y), N(x,y) . . . ) die Lage der elektrischen Sperrschicht (S) definiert.

3. Verfahren zur Abbildung elektrischer Sperrschichten in Halbleitern, deren Oberfläche von einem in einem Rastermikroskop erzeugten Korpuskularstrahl punkt- oder zeilenweise abgetastet wird und bei dem korpuskularstrahl-induzierte Signale in Abhängigkeit vom Ort des Korpuskularstrahls auf der Halbleiteroberfläche aufgezeichnet werden, dadurch gekennzeichnet, dass der Korpuskularstrahl entlang einer Rasterlinie über eine elektrische Sperrschicht hinweggeführt wird, dass die entlang der Rasterlinie gemessenen korpuskularstrahl-induzierten Signale logarithmiert werden, dass auf der ansteigenden und der abfallenden Flanke des logarithmierten korpuskularstrahl-induzierten Gesamtsignals Punkte (F(x,y)) auf der Rasterlinie ausgewählt werden, an denen die Flanken des logarithmierten Gesamtsignals möglichst linear sind, dass die Steigungen des logarithmierten Gesamtsignals in diesen Punkten (F(x,y)) ermittelt werden, dass Geraden mit den ermittelten Steigungen durch die den ausgewählten Rasterpunkten (F(x,y)) auf dem logarithmierten Gesamtsignal entsprechenden Punkte (F) gelegt werden und dass die Schnittpunkte (T) dieser Geraden mit einer durch das Maximum des logarithmierten Gesamtsignals gelegten horizontalen Geraden die Breite (b) der elektrischen Sperrschicht entlang der Rasterlinie definieren.

4. Verfahren nach Anspruch 1, 2 oder 3, dadurch gekennzeichnet, dass die durch statistische Phänomene (Rauschen) hervorgerufenen Effekte durch Mittelungen über benachbarte Rasterpunkte hinweg unterdrückt werden.

5. Verfahren nach Anspruch 4, dadurch gekennzeichnet, dass die Anzahl der Rasterpunkte, über die hinweg gemittelt wird, so gewählt wird, dass eine Hinzunahme oder eine Weglassung eines Rasterpunktes in bezug auf diese Anzahl von Rasterpunkten das Ergebnis praktisch nicht ändert.

## Claims

1. A method of reproducing electrical barrier layers in semiconductors, the surface of which is scanned point-by-point or row-by-row by a corpuscular beam produced in a scanning microscope and where corpuscular beam-induced signals are recorded in dependence upon the location of the corpuscular beam on the semiconductor surface, characterised in that a first scanning point (P(x,y)) is selected such that the minimum of one line scan leads from the first scanning point (P(x,y)) along more or less the shortest path across a further point (H) located on the electrical barrier layer which is to be localised and corpuscular beam-induced signals produced along at least one line scan are virtually identical with the corresponding corpuscular beam-induced signals which are produced in each case for that above-mentioned line scan corresponding to another line scan not extending from the first scanning point (P(x,y)) but from a second scanning point (P(x+Δx, y+Δy)) adjacent to the first scanning point (P(x,y)), and at least in the vicinity of the respective associated further point (H) leads across the electric barrier layer which is to be localised, where the respective maximum of the corpuscular beam-induced signals along each such line scan is then correlated with a point on the electrical barrier layer (S).

2. A method of reproducing electrical barrier layers in semiconductors, the surface of which is scanned point-by-point or row-by-row by a corpuscular beam generated in a scanning microscope, and where the corpuscular beam-induced signals are recorded in dependence upon the location of the corpuscular beam on the semiconductor surface, characterised in that a first scanning point (M(x,y)) is selected to be such that the corpuscular beam-induced signal measured at this first scanning point (M(x,y)) has the highest value compared with the corpuscular beam-induced signals measured at the other scanning points, that commencing from the first scanning point (M(x,y)) a second scanning point (N(x,y)) in the direct vicinity of the latter is selected, which is such that the corpuscular beam-induced signal measured at this second scanning point (N(x,y)) has the highest value compared with the corpuscular beam-induced signals measured at the further scanning points in the direct vicinity of the first scanning point (M(x,y)), where the corpuscular beam-induced signal measured at the first scanning point (M(x,y)) is disregarded, that in the direct vicinity of the second scanning point (N(x,y)) a third scanning point is selected, whose corpuscular beam-induced signal has the highest value, disregarding the signals measured at the first and second scanning points (M(x,y), N(x,y)), and so on, where the sequence of the thus selected scanning points (M(x,y), N(x,y) ...) defines the position of the electrical barrier layer (S).

3. A method of reproducing electrical barrier layers in semiconductors, the surface of which is scanned point-by-point or row-by-row by a corpuscular beam generated in a scanning microscope, and where the corpuscular beam-induced signals are recorded in dependence upon the location of the corpuscular beam on the semiconductor surface, characterised in that the corpuscular beam is conducted across an electrical barrier layer along a line scan, that the corpuscular beam-induced signals measured along the line scan are logarithmized, that on the rising and falling flank of the logarithmized corpuscular beam-induced overall signal those points (F(x,y)) on the line scan are selected at which the flanks of the logarithmized overall signal are as linear as possible, that the gradients of the logarithmized overall signal at these points (F,x,y)) are determined, that straight lines having the determined gradients are positioned through the points (F) which correspond to the selected scanning points (F(x,y)) on the logarithmized overall signal, and that the intersection points (T) of these straight lines with a horizontal straight line extending through the maximum of the logarithmized overall signal define the breadth (b) of the electrical barrier layer along the line scan.

4. A method as claimed in Claim 1, 2 or 3, characterised in that the effects produced by statistical phenomena (noise) are suppressed by averaging across adjacent scanning points.

5. A method as claimed in Claim 4, characterised in that the number of the scanning points across which the averaging is carried out is selected such that the addition of or the omission of a scanning point relative to this number of scanning points causes virtually no change in the result.

## Revendications

1. Procédé pour former l'image de couches d'arrêt électriques dans des semiconducteurs, dont la surface est balayée de façon ponctuelle ou ligne-par-ligne par un faisceau corpusculaire produit dans un microscope à balayage, et selon lequel des signaux induits par le faisceau corpusculaire sont enregistrés en fonction de l'emplacement du faisceau corpusculaire sur la surface semiconductrice, caractérisé par le fait qu'on choisit un premier point de réseau (P(x,y)) de manière que les signaux induits par le faisceau corpusculaire, qui sont produits le long d'au moins une ligne du réseau (line scan) (au moins cette ligne du réseau reliant par le chemin par exemple le plus court un premier point (P(x,y)) du réseau respectivement à un autre point (H) situé sur la couche d'arrêt électrique devant être localisée), coïncident pratiquement avec les signaux correspondants induits par le faisceau corpusculaire, qui sont produits par le fait qu'à chacune des lignes du réseau mentionnées plus haut correspond respectivement une autre ligne du réseau, qui part non pas du premier point (P(x,y)) du réseau, mais d'un second point (P(x + Δx, y + Δy)) voisin du premier point (P(x,y)) du réseau, et aboutit au moins à proximité de l'autre point respectivement associé (H), à travers la couche d'arrêt électrique devant être localisée, le maximum respectif des signaux induits par le faisceau corpusculaire le long de chaque ligne de ce type du réseau étant alors mis en corrélation avec un point situé sur la couche d'arrêt électrique (S).

2. Procédé pour former l'image de couches d'arrêt électriques dans des semiconducteurs, dont la surface est balayée de façon ponctuelle ou ligne-par-ligne par un faisceau corpusculaire produit dans un microscope à balayage, et selon lequel des signaux induits par le faisceau corpusculaire sont enregistrés en fonction de l'emplacement du faisceau corpusculaire sur la surface semiconductrice, caractérisé par le fait qu'on choisit un premier point du réseau (M(x,y)) de manière que le signal induit par le faisceau corpusculaire et mesuré en ce premier point (M(x,y)) du réseau possède la valeur maximale par rapport aux signaux induits par le faisceau corpusculaire et mesurés au niveau d'autre point du réseau, qu'à partir du premier point (M(x,y)) du réseau, on choisit un second point (N(x,y)) du réseau situé dans le voisinage immédiat du premier point de telle manière que le signal induit par le faisceau corpusculaire et mesuré en ce second point (N(x,y)) du réseau possède la valeur maximale par rapport aux signaux induits par le faisceau corpusculaire et mesurés au niveau des autres points du réseau situés au voisinage direct du premier point (M(x,y)) du réseau, le signal induit par le faisceau corpusculaire et mesuré au niveau du premier point (M(x,y)) du réseau n'étant pas pris en compte, et que, dans l'environnement immédiat du second point (N(x,y)) du réseau on choisit un troisième point du réseau, dont le signal induit par le faisceau corpusculaire possède la valeur maximale, lorsqu'on ne tient pas compte des premier et second points (M(x,y), N(x,y)) du réseau, et ainsi de suite, la suite des points (Mx,y), N(x,y) . . . ) du réseau ainsi choisis définissant la position de la couche d'arrêt électrique (S).

3. Procédé pour former l'image de couches d'arrêt électriques dans des semiconducteurs, dont la surface est balayée de façon ponctuelle ou ligne-par-ligne par un faisceau corpusculaire produit dans un microscope à balayage, et selon lequel des signaux induits par le faisceau corpusculaire sont enregistrés en fonction de l'emplacement du faisceau corpcusculaire sur la surface semiconductrice, caractérisé par le fait qu'on déplace le faisceau corpusculaire le long d'une ligne de balayage sur la couche d'arrêt électrique, qu'on calcule le logarithme des signaux induits par le faisceau corpusculaire et mesurés le long de la ligne du réseau, qu'on choisit, sur la ligne du réseau, au niveau du flanc montant et du flanc descendant du signal global induit par le faisceau corpusculaire mis sous forme logarithmique, des points (F(x,y)), au niveau desquels les flancs du signal global mis sous forme logarithmique sont aussi rectilignes que possible, qu'on détermine les pentes du signal global mis sous forme logarithmique au niveau de ces points (F,x,y)), qu'on trace des droites possédant les pentes déterminées et passant par les points (F) correspondant aux points choisis (F(x,y)) du réseau dans le signal global mis sous forme logarithmique, les points (T) d'intersection de ces droites avec une droite horizontale passant par le maximum du signal global mis sous forme logarithmique, définissant la largeur (b) de la couche d'arrêt électrique, le long de la ligne du réseau.

4. Procédé suivant la revendication 1, 2 ou 3, caractérisé par le fait que les effets produits par des phénomènes statistiques (bruits) sont supprimés au moyen de formation de moyennes sur des points voisins du réseau.

5. Procédé suivant la revendication 4, caractérisé par le fait qu'on choisit le nombre des points du réseau, sur lesquels la moyenne est exécutée, de manière qu'une adjonction d'un point du réseau à ce nombre de points du réseau ou la suppression d'un point du réseau de ce nombre ne modifie pratiquement pas le résultat.

# FIG 1

# FIG 2

## FIG 3

Al

Si$_3$N$_4$

Si

n$^+$-E

p-B

## FIG 4

Al

y

x

n$^+$-E

R

p-B

1$\mu$m

# FIG 5

Al

$Si_3N_4$

y

x

$n^+$-E

S

p-B

1 $\mu$m

# FIG 6

y

$P(x,y)$

$P(x+\Delta x, y+\Delta y)$.

x

H

S

FIG 7

FIG 8

# FIG 9